(19) Europäisches Patentamt
European Patent Office
Office européen des brevets

(11) **EP 1 060 401 B1**

(12) **EUROPÄISCHE PATENTSCHRIFT**

(45) Veröffentlichungstag und Bekanntmachung des Hinweises auf die Patenterteilung:
**17.03.2004   Patentblatt 2004/12**

(51) Int Cl.$^7$: **G01R 33/028**

(21) Anmeldenummer: **98966795.1**

(22) Anmeldetag: **21.12.1998**

(86) Internationale Anmeldenummer:
**PCT/DE1998/003748**

(87) Internationale Veröffentlichungsnummer:
**WO 1999/045406 (10.09.1999 Gazette 1999/36)**

(54) **MAGNETFELDSENSOR**

MAGNETIC FIELD SENSOR

DETECTEUR DE CHAMP MAGNETIQUE

(84) Benannte Vertragsstaaten:
**CH DE ES FR GB IT LI SE**

(30) Priorität: **06.03.1998   DE 19809742**

(43) Veröffentlichungstag der Anmeldung:
**20.12.2000   Patentblatt 2000/51**

(73) Patentinhaber: **ROBERT BOSCH GMBH**
**70442 Stuttgart (DE)**

(72) Erfinder:
• **FUNK, Karsten**
  **D-70195 Stuttgart (DE)**
• **FREY, Wilhelm**
  **D-70178 Stuttgart (DE)**

(56) Entgegenhaltungen:
**DE-A- 3 512 180          FR-A- 998 040**

• **DATABASE INSPEC INSTITUTE OF ELECTRICAL ENGINEERS, STEVENAGE, GB Inspec No. 5751721, NAKANE H ET AL: "Micromechanical resonant magnetic sensor in standard CMOS" XP002103267 & TRANDUCERS 97. 1997 INTERNATIONAL CONFERENCE ON SOLID-STATE SENSORS AND ACTUATORS. DIGEST OF TECHNICAL PAPERS (CAT. NO.97TH8267), PROCEEDINGS OF INTERNATIONAL SOLID STATE SENSORS AND ACTUATORS CONFERENCE (TRANSDUCERS '97), CHICAGO, IL, USA, 16-19 JUN, Seiten 405-408 vol.1, ISBN 0-7803-3829-4, 1997, New York, NY, USA, IEEE, USA**

EP 1 060 401 B1

**Beschreibung**

STAND DER TECHNIK

Die vorliegende Erfindung betrifft einen Magnetfeldsensor, und insbesondere einen in der Technologie der Oberflächenmikromechanik herstellbaren Magnetfeldsensor.

Obwohl auf beliebige Magnetfeldsensoren anwendbar, werden die vorliegende Erfindung sowie die ihr zugrundeliegende Problematik in bezug auf einen in der Technologie der Oberflächenmikromechanik herstellbaren Magnetfeldsensor zum Einsatz in der Automobiltechnik vorgesehenen erläutert.

Magnetfeldsensoren können in der Automobiltechnik vielfältig eingesetzt werden, beispielsweise beim Antiblockiersystem (ABS) oder bei der Antischlupfregelung (ASR) als Radsensoren, als Positionssensor bei Nadelventilen bzw. Zündimpulsgebern, als Lenkradwinkelgeber, als Kurbelwellenpositionsgeber usw.. Die Anforderungen an diese Magnetfeldsensoren hinsichtlich mechanischer Belastbarkeit, wie z.B. Schockbelastbarkeit, und Temperaturbelastbarkeit sind üblicherweise extrem hoch.

Im Stand der Technik gibc es eine ganze Reihe von bekannten Magnetfeldsensoren, welche die Kraftwirkung eines Magnetfeldes auf einen stromdurchflossenen Leiter ausnutzen. Das bekannteste Beispiel dafür ist der Hallsensor.

Als nachteilhaft bei den obigen bekannten Ansätzen hat sich die Tatsache herausgestellt, daß diese den hohen mechanischen und/oder thermischen Belastungen nicht standhalten und/oder eine zu geringe Empfindlichkeit aufweisen und/oder sehr kostspielig sind.

Weiterhin ist aus der Druckschrift DE 3512180 ein Magnetfeldsensor bekannt, bei dem eine Spannungserfassungseinrichtung, eine Magnetfeldermittlungseinrichtung und eine Deformationseinrichtung vorgesehen sind. Die Spannungserfassung erfolgt jedoch nicht direkt an einer Leiterschleife und die Deformation erfolgt nicht mit kapazitiver Kopplung.

Weiterhin ist aus der Druckschrift Beverly et al.:

"Micromechanical resonant magnetic sensor in standard DMOS", Transducers 97, Int. Conf. on Solid-State Sensors and Actuators, Seite 405-408, ein Magnetfeldsensor bekannt, bei dem jedoch die Kraftwirkung auf eine stromdurchflossene Spule in einem magnetischen Feld zur Magnetfeldmessung herangezogen wird.

Aufgabe und Vorteile der Erfindung

Die der vorliegenden Erfindung zugrundeliegende Aufgabe ist es, einen Magnetfeldsensor bereitzustellen, der hohen mechanischen Belastungen standhält und eine hohe Empfindlichkeit bei gleichzeitig geringer Temperaturabhängigkeit aufweist. Diese Aufgabe wird durch den Magnetfeldsensor gemäß dem Hauptanspruch gelöst. Die der vorliegenden Erfindung zugrundeliegende Idee besteht darin, daß eine Leiterschleife, deren Fläche moduliert wird, d. h. eine vorgebbare Zeitabhängigkeit aufweist, solange spannungslos bleibt, wie kein Magnetfeld durch sie hindurchtritt. Sobald jedoch diese Leiterschleife einem Magnetfeld ausgesetzt ist, wird durch die Flächenmodulation der magnetische Fluß $\Phi$ stetig verändert, was eine Spannungsinduktion mit sich bringt, die proportional zur magnetischen Flußdichte und zur zeitlichen Flächenänderung ist. Diese Spannung wird an den Enden der Leiterschleife abgegriffen und entsprechend der mechanischen Anregung ausgewertet. Mit dem erfindungsgemäßen Magnetfeldsensor können sowohl konstante Magnetfelder als auch magnetische Wechselfelder bis zu einer systembedingten Grenzfrequenz erfaßt werden

In den Unteransprüchen finden sich vorteilhafte Weiterbildungen und Verbesserungen des in Anspruch 1 angegebenen Magnetfeldsensors.

Gemäß einer bevorzugten Weiterbildung umschließt die Leiterschleife im undeformierten Zustand eine Fläche mit zwei im wesentlichen zueinander parallelen Längsseiten und deformiert die Deformationseinrichtung die zwei Längsseiten zur Änderung der umschlossenen Fläche. So läßt sich vorteilhafterweise eine große Flächenänderung realisieren.

Gemäß einer weiteren bevorzugten Weiterbildung ist die Deformationseinrichtung derart gestaltet ist, daß sie die zwei Längsseiten zu gegensinnigen resonanten Biegeschwingungen anregt. So läßt sich vorteilhafterweise eine besonders große Flächenänderung unter Ausnutzung der Resonanzüberhöhung realisieren.

Gemäß einer weiteren bevorzugten Weiterbildung ist die Leiterschleife derart gestaltet ist, daß die gegensinnigen resonanten Biegeschwingungen eine andere Resonanzfrequenz aufweisen als die entsprechenden gleichsinnigen resonanten Biegeschwingungen. Damit lassen sich vorteilhafterweise Interferenzen mit den ungewollten gleichsinnigen resonanten Biegeschwingungen vermeiden, bei denen die Nettoflächenänderung im wesentlichen Null ist.

Gemäß einer weiteren bevorzugten Weiterbildung ist die Deformationseinrichtung derart gestaltet ist, daß sie die deformierbaren Abschnitte über eine kapazitive Kopplung deformiert. Damit gibt es weder Reibungsverluste noch Verschleiß bei der Anregung. Außerdem sind solche kapazitiven Anregungseinrichtungen aus anderen Bereichen, wie z.B. Kammstrukturen von Beschleunigungssensoren, bekannt.

Gemäß einer weiteren bevorzugten Weiterbildung ist Magnetfeldsensor in der Technologie der Oberflächenmikromechanik hergestellt und hat ein Substrat, das vorzugsweise aus Silizium (oder einem anderen elektrisch leitenden Material) ist. Die Leiterschleife weist im wesentlichen eine Rechteckform auf, deren Längsseiten schwebend über dem Substrat angeordnet sind und durch die Deformationseinrichtung deformierbar sind und deren Breitseiten schwebend am Substrat aufgehängt sind. Gerade diese Ausführungsform weist eine hohe Empfindlichkeit bei gleichzeitig geringer Temperaturabhängigkeit auf.

Gemäß einer weiteren bevorzugten Weiterbildung weist die Leiterschleife eine durchgehende nicht-deformierbare erste Breitseite mit einer größere Dicke als die Längsseiten, die über mindestens einen deformierbaren schwebenden Steg mit im wesentlichen der Dicke der Längsseiten mit mindestens einem im Substrat verankerten Anschlußpad verbunden ist, auf. Diese starre erste Breitseite stabilisiert die Breite der Fläche.

Gemäß einer weiteren bevorzugten Weiterbildung weist die Leiterschleife eine geteilte nicht-deformierbare zweite Breitseite mit einer größere Dicke als die Längsseiten, deren Teile über einen jeweiligen deformierbaren schwebenden Steg mit im wesentlichen der Dicke der Längsseiten mit einem jeweiligen im Substrat verankerten Anschlußpad verbunden ist, auf. Diese geteilte starre zweite Breitseite stabilisiert die Breite der Fläche ebenfalls und ermöglicht einen zweckmäßigen Abgriff der induzierten Spannung.

Gemäß einer weiteren bevorzugten Weiterbildung sind die Längsseiten an ihrem ersten Ende über einen deformierbaren schwebenden ersten Federsteg mit im wesentlichen der Dicke der Längsseiten mit einem im Substrat verankerten Anschlußpad verbunden. Bei dieser Ausführungsform entfällt vorteilhafterweise die geteilte starre zweite Breitseite, so daß die Struktur einfacher wird.

Gemäß einer weiteren bevorzugten Weiterbildung sind die Längsseiten an ihrem zweiten Ende über einen deformierbaren schwebenden zweiter. Federsteg mit im wesentlichen der Dicke der Längsseiten mit der durchgehenden nicht-deformierbaren ersten Breitseite verbunden.

Gemäß einer weiteren bevorzugten Weiterbildung ist in der Mitte der deformierbaren Längsseiten eine Zusatzmasse über dem Substrat schwebend vorgesehen. Diese Zusatzmasse dient vorteilhafterweise zur Einstellung der Resonanzfrequenz.

Gemäß einer weiteren bevorzugten Weiterbildung ist als Deformationseinrichtung eine mit den Längsseiten verbundene Kammantriebseinrichtung vorgesehen ist. Diese Verbindung kann entweder direkt sein, indem auf den Längsseiten Kammzinken vorgesehen sind, oder indirekt sein, indem auf einer möglicherweise vorhandenen Zusatzmassen Kammzinken vorgesehen sind.

ZEICHNUNGEN

Ausführungsbeispiele der Erfindung sind in den Zeichnungen dargestellt und in der nachfolgenden Beschreibung näher erläutert.

Es zeigen:

Fig. 1 eine schematische Darstellung zur Erläuterung des Meßprinzips des erfindungsgemäßen Magnetfeldsensors;

Fig. 2 eine schematische Darstellung einer ersten Ausführungsform des erfindungsgemäßen Magnetfeldsensors;

Fig. 3 einen Stromlaufplan der ersten Ausführungsform des erfindungsgemäßen Magnetfeldsensors;

Fig. 4 eine schematische Darstellung einer zweiten Ausführungsform des erfindungsgemäßen Magnetfeldsensors;

Fig. 5 eine schematische Darstellung einer dritten Ausführungsform des erfindungsgemäßen Magnetfeldsensors;

Fig. 6 eine schematische Darstellung einer vierten Ausführungsform des erfindungsgemäßen Magnetfeldsensors;

Fig. 7 eine schematische Darstellung einer fünften Ausführungsform des erfindungsgemäßen Magnetfeldsensors.

BESCHREIBUNG DER AUSFÜHRUNGSBEISPIELE

In den Figuren bezeichnen gleiche Bezugszeichen gleiche oder funktionsgleiche Komponenten.

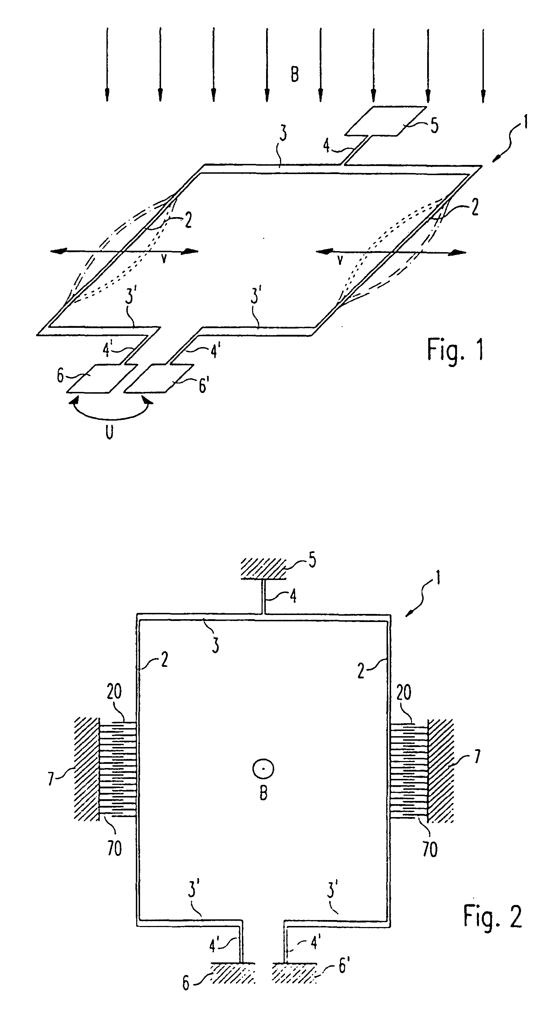

Fig. 1 ist eine schematische Darstellung zur Erläuterung des Meßprinzips des erfindungsgemäßen Magnetfeldsensors.

In Fig. 1 bezeichnet 1 allgemein eine Leiterschleife von im wesentlichen rechteckiger Form, 2 deformierbare Längsseiten der Leiterschleife 1, 3 und 3' nicht-deformierbare Breitseiten der Leiterschleife 1, 4 und 4' deformierbare Stege sowie 5 und 6, 6' Anschlußpads. B bezeichnet ein externes Magnetfeld, U eine induzierte Spannung und v die Bewegungs- bzw. Deformationsrichtung der Längsseiten 2.

Das Meßprinzips des erfindungsgemäßen Magnetfeldsensors liegt einfach darin, daß durch eine geeignete mechanische Anregung eine oszillierende Flächenänderung dA/dt der Fläche A der Leiterschleife 1 erzeugt wird, welche in Gegenwart eines Magnetfeldes B eine induzierte Spannung U an den Anschlußpads 6, 6' erzeugt. Die Modulationsfunktion der Fläche A, z.B. $A = A_0 \, v\cos \omega t$, wird zum Demodulieren der entsprechend modulierten induzierten Spannung U hergenommen, woraus sich eine Spannung ergibt die proportional zur magnetischen Flußdichte E ist und deren Vorzeichen die Richtung der magnetischen Feldlinien angibt. Absolutwerte lassen sich durch eine geeignete Eichung oder durch die genauer Geometrie der Anordnung festlegen.

Für ein externes magnetisches Wechselfeld gilt folgende Besonderheit. Setzt man für den magnetischen Fluß $\Phi = B \cdot A$ mit $A = A_0 \cos \omega t$ und $B = B_0 \cos \Omega t$, wobei $\omega$ die Winkelgeschwindigkeit der Flächenänderung und $\Omega$ die Winkelgeschwindigkeit der Magnetfeldänderung sind, so ergibt sich für die induzierte Spannung U:

$$U = - d\Phi/dt = - d/dt[A_0 \cos \omega t \times B_0 \cos \Omega t]$$

Das Meßsignal ist dann also ein amplitudenmoduliertes Signal mit unterdrücktem Träger. Im Frequenzspektrum erscheinen nur zwei Seitenbänder im Abstand $+/-\Omega$ um den Träger $\omega$ herum. Durch aus der allgemeinen Nachrichtentechnik wohlbekannte Demodulationsverfahren, wie z.B. Multiplikation mit der Trägerfrequenz $\omega$ und anschließende Tiefpaßfilterung, kann leicht auf die Amplitude und Richtung bzw. die Winkelgeschwindigkeit $\Omega$ der Magnetfeldänderung geschlossen werden.

Fig. 2 ist eine schematische Darstellung einer ersten Ausführungsform des erfindungsgemäßen Magnetfeldsensors.

In Fig. 2 bezeichnen zusätzlich zu den bereits eingeführten Bezugszeichen 20 eine an den Längsseiten 2 vorgesehene Kammstruktur und 70 eine in einer Verankerung 7 vorgesehene Kammstruktur, welche in die Kammstruktur 20 eingreift.

Diese erste Ausführungsform ist, wie auch alle anderen hier beschriebenen Ausführungsformen, in der Technologie der Oberflächenmikromechanik hergestellt, und zwar mit einem Silizium-Substrat.

Die Leiterschleife 1, die im wesentlichen eine Rechteckform aufweist, hat ihre Längsseiten 2 als dünne Balken und ihre Breitseiten 3, 3' als dickere Balken schwebend über dem Substrat angeordnet. Dabei ist die durchgehende dicke, d.h. nicht-deformierbare, erste Breitseite 3 über den dünnen, d.h. deformierbaren, schwebenden Steg 4 mit dem im Substrat verankerten Anschlußpad 5 verbunden. Die geteilte dicke, d.h. nicht-deformierbare, zweite Breitseite 3' ist über einen jeweiligen dünnen, d.h. deformierbaren, schwebenden Steg 4' mit dem jeweils entsprechenden im Substrat verankerten Anschlußpad 6, 6' verbunden.

Auch die Kammeinrichtungen 20, 70 sind schwebend über dem Substrat vorgesehen, wobei die Verankerung 7 im Substrat verankert ist.

Die elastische Anbindung der Leiterschleife 1 an das Substrat mittels der dünnen Stege 4, 4' ermöglicht, daß eine Modenseparation zwischen einer gleichsinnigen Bewegung der biegsamen Längsseiten 2, bei der beide in die gleiche Richtung ausgelenkt werden, und einer gegensinnigen Bewegung, bei der beide in entgegengesetzte Richtungen ausgelenkt werden, erreichbar ist. Diese Modenseparation beruht darauf, daß bei der gleichsinnigen Bewegung die Stege 4, 4' und die Breitseiten 3, 3' teilweise mitschwingen, während bei der gegensinnigen Bewegung diese Bauteile ortsfest bleiben. Die mechanische Eigenfrequenz der Systems wird also bei der gleichsinnigen Bewegung geringer sein als bei der gegensinnigen Bewegung.

Die Anregung der Leiterschleife 1 wird über die an sich aus Beschleunigungssensoren und Kammantrieben bekannten Kammstrukturen 20, 70 realisiert. Durch eine zweckmäßigerweise sinusförmige Spannung werden elektrostatische Anziehungskräfte erzeugt, welche bewirken, daß die Kammstruktur 20 in die Kammstruktur 70 hineingezogen bzw. daraus hinausgedrängt wird. Die mechanische Auslenkung der Längsseiten 2 kann dabei durch dieselbe oder eine zusätzliche, gleichartig aufgebaute Kammstruktur gemessen werden, basierend auf diesen Meßresultaten kann die mechanische Anregung hinsichtlich ihrer Frequenz und Amplitude konstant gehalten werden. Die Konstanthaltung dieser mechanischen Parameter ist für eine genaue Messung wichtig. Geeignete Regelschaltungen, welche zu diesem Zweck dienen, sind im Stand der Technik weitläufig bekannt. Zweckmäßigerweise wird eine Resonanzanregung durchgeführt, da dann einerseits die besagte Modenselektion möglich ist und andererseits die mechanische Güteüberhöhung ausnutzbar ist, was zu einer Reduzierung der notwendigen elektrischen Anregungsamplitude führt. Um die Dämpfung möglichst stark zu reduzieren, kann der Magnetfeldsensor auch im Unterdruck betrieben werden.

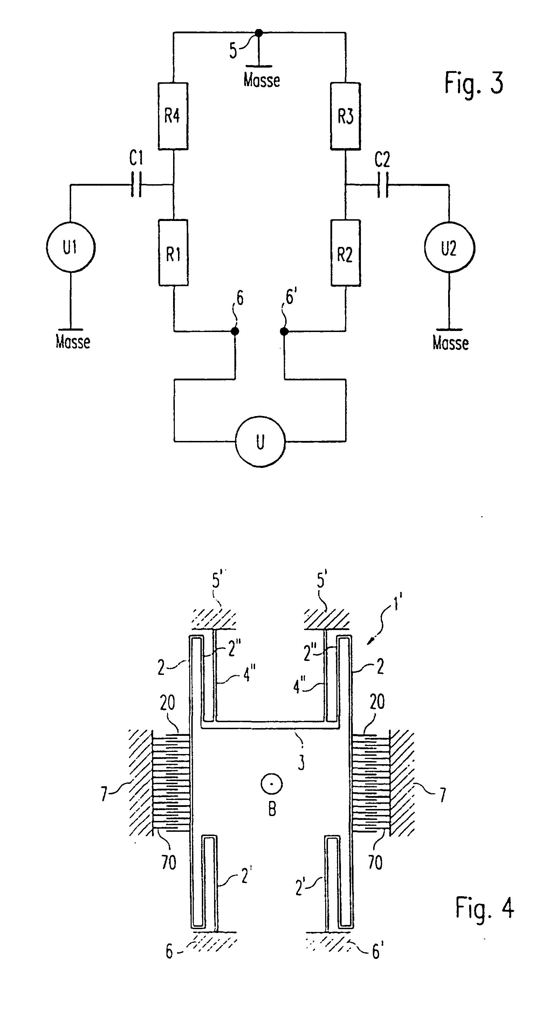

Fig. 3 ist ein Stromlaufplan der ersten Ausführungsform des erfindungsgemäßen Magnetfeldsensors.

In Fig. 3 bezeichnen zusätzlich zu den bereits eingeführten Bezugszeichen U1 und U2 die Anregungsspannungen der Kammeinrichtung 70, C1 und C2 die kapazitive Kopplung zwischen den Kammeinrichtungen 20, 70, R1 bis R4 Ersatzwiderstände der entsprechenden Leiterschleifenabschnitte und MASSE das Nullpotential bzw. Erdpotential.

An der Leiterschleife 1 liegt bei ruhenden Längsseiten 2 eine Spannung U an die proportional zur Änderung dB/dt des Magnetfeldes B ist. Dies entspricht dem trivialen Ansatz, nach dem bekannte Induktionsmeßgeräte arbeiten. Wird die Leiterschleife elektrostatisch mit den Spannungen U1 und U2 über die Kammstrukturen 20, 70 angetrieben, so gilt das Ersatzschaltbild nach Fig. 3.

Dabei ist insbesondere folgendes zu beachten. Wird zur Anregung der Leiterschleife 1 ein sinusförmiger Wechselstrom an die Kammstrukturen 20, 70 angelegt, so fließt auch ein sinusförmiger Wechselstrom durch die Widerstände R3 und R4, der einen entsprechenden Spannungsabfall erzeugt, welcher das Meßsignal der induzierten Spannung U verfälscht.

Gegen diese Verfälschung lassen sich folgende Maßnahmen ergreifen.

Erstens kann eine Minimierung durch Erzeugung eines Gleichtaktsignals erfolgen. Da am Ausgang der Leiterschleife 1 (Anschlußpads 6, 6') ein Differenzsignal gemessen wird, kann der Einfluß minimiert werden, indem man ebenfalls einen solchen Spannungsabfall erzeugt. Dazu wird U1 gleich U2 geschaltet. Unter der Voraussetzung, daß C1 = C2 und R3 = R4 gilt ergeben sich daraus identische Spannungsabfälle, welche sich bei der Differenzspannungsmessung am Ausgang der Leiterschleife 1 herausheben.

Zweitens kann eine Phasendiskriminierung bei resonanter Anregung durchgeführt werden. Der Strom i durch die kapazitive Struktur C1, C2 hat bei sinusförmiger Anregungsspannung einen kosinusförmigen Verlauf, da i = C dU/dt für die Kondensatoren C1, C2 gilt. Wird die Kammstruktur 20, 70 mit einer sinusförmigen Spannung angeregt, so hat auch die für den Antrieb relevante elektrostatische Kraft eine Komponente mit der Zeitfunktion $F_0 \sin \omega t$. Bei resonanter Anregung folgt die Bewegungsamplitude um 90° zu dieser Kraft versetzt, also mit einer Zeitabhängigkeit $\cos \omega t$ wie auch der störende Strom. Maßgeblich für die durch das Magnetfeld induzierte Spannung U ist aber die Geschwindigkeit der Bewegung, welche wiederum um 90° versetzt erfolgt, also mit einer Zeitabhängigkeit $-\sin \omega t$. Damit ergibt sich ein Phasenunterschied von 90° zwischen der induzierten Spannung U und den über den Widerständen R3 und R4 abfallenden parasitären Spannungen. Somit kann der störende Strom durch eine phasensensitive Demodulation herausgefiltert werden.

Drittens kann eine Diskriminierung im Frequenzbereich erfolgen. Die durch ein Magnetfeld B induzierte Spannung U ist, wie gesagt, proportional zur Geschwindigkeit der Bewegung, also hat z.B. die Zeitabhängigkeit $-\sin \omega t$. Die elektrostatisch erzeugte Kraft $F_0 \sin \omega t$ ist proportional zum Quadrat der elektrischen Anregungsspannung U1 bzw. U2.

Mit anderen Worten muß gemäß bekannter trigonometrischer Identitäten die Anregungsfrequenz, welche einen Kraftverlauf $F_0 \sin \omega t$ erzeugt, ½ $\omega t$ betragen. Der Spannungsabfall über den Widerständen R3 und R4 hat dann ebenfalls eine Zeitabhängigkeit $\cos$ ½ $\omega t$. Daher läßt sich der ungewünschte Spannungsabfall durch elektrische Hochpaßfilterung entfernen.

Fig. 4 ist eine schematische Darstellung einer zweiten Ausführungsform des erfindungsgemäßen Magnetfeldsensors.

In Fig. 4 bezeichnen zusätzlich zu den bereits eingeführten Bezugszeichen 1'' die Leiterschleife gemäß der zweiten Ausführungsform, 2' und 2'' einen jeweiligen dünnen, d.h. deformierbaren, ersten bzw. zweiten Federsteg, 5' zwei Anschlußpads welche über einen jeweiligen dünnen, d.h. deformierbaren, Steg 4'' mit der breiten, d.h. nicht-deformierbaren, Breitseite 3 verbunden sind.

Im Unterschied zur obigen ersten Ausführungsform sind bei der zweiten Ausführungsform zwei Anschlußpads 5, 5' mit der starren Breitseite 3 über die Stege 4'' verbunden.

Die Längsseiten 2 sind an ihrem ersten (unteren) Ende über den deformierbaren schwebenden ersten Federsteg 2' mit im wesentlichen der Dicke der Längsseiten 2 mit dem im Substrat verankerten Anschlußpad 6 bzw. 6' verbunden. Mit anderen Worten ist bei dieser Ausführungsform nur eine obere starre Breitseite 3 vorgesehen.

Weiterhin sind die Längsseiten 2 an ihrem zweiten (oberen) Ende über den deformierbaren schwebenden zweiten Federsteg 2'' mit im wesentlichen der Dicke der Längsseiten 2 mit der durchgehenden nichtdeformierbaren ersten Breitseite 3 verbunden.

Ansonsten ist die zweite Ausführungsform funktions- und aufbaugleich wie die erste Ausführungsform.

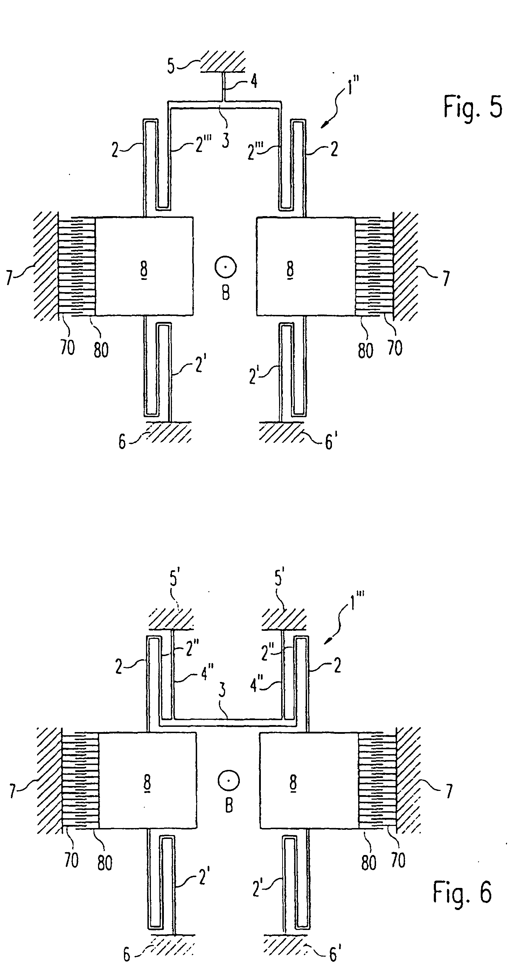

Fig. 5 ist eine schematische Darstellung einer dritten Ausführungsform des erfindungsgemäßen Magnetfeldsensors.

In Fig. 5 bezeichnen zusätzlich zu den bereits eingeführten Bezugzeichen 1''' die Leiterschleife gemäß der dritten Ausführungsform, 2''' einen jeweiligen dünnen, d.h. deformierbaren, Federsteg und 8 eine in die Längsseiten integrierte Zusatzmasse.

Im Unterschied zur obigen ersten und zweiten Ausführungsform ist bei der dritten Ausführungsform in der Mitte der deformierbaren Längsseiten 2 die Zusatzmasse 8 über dem Substrat schwebend vorgesehen, mittels derer die Resonanzfrequenz der Längsseiten 2 abstimmbar ist. Auch ist die Kammstruktur 80 an der Zusatzmasse 8 anstelle der Kammstruktur 20 vorgesehen.

Desweiteren ist die Anbindung der Längsseiten 2 an ihrer oberen Seite an die starre Breitseite 3 über die mdifizierten Federstege 2''' realisiert. Die starre Breitseite 3 ist nur über einen Steg 4 an einem Anschlußpad 5 verankert.

Ansonsten ist die dritte Ausführungsform funktions- und aufbaugleich wie die zweite Ausführungsform.

Fig. 6 ist eine schematische Darstellung einer vierten Ausführungsform des erfindungsgemäßen Magnetfeldsensors.

In Fig. 6 bezeichnet zusätzlich zu den bereits eingeführten Bezugszeichen 1''' die Leiterschleife gemäß der vierten Ausführungsform. Diese vierte Ausführungsform entspricht der zweiten Ausführungsform unter Hinzunahme der Zusatzmasse 8.

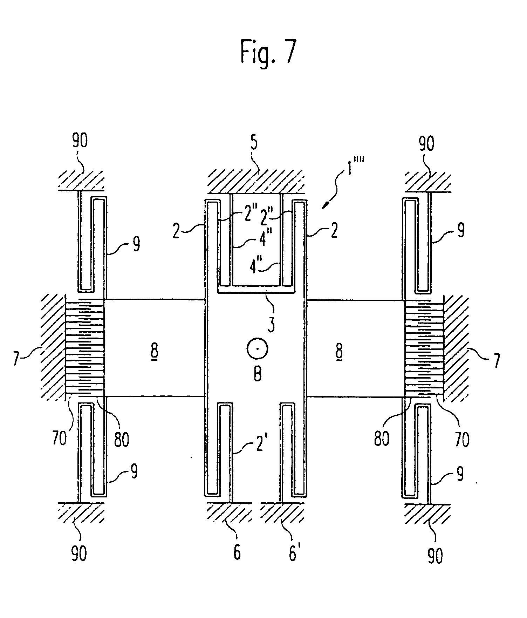

Fig. 7 ist eine schematische Darstellung einer fünften Ausführungsform des erfindungsgemäßen Magnetfeldsensors.

In Fig. 7 bezeichnen zusätzlich zu den bereits eingeführten Bezugszeichen 1'''' die Leiterschleife gemäß der fünften Ausführungsform und 9 jeweilige dünne, d.h. deformierbare Verbindungsstege zu entsprechenden zusätzlichen Verankerungen 90 zum Substrat.

Diese fünfte Ausführungsform entspricht der vierten Ausführungsform unter Hinzunahme der zusätzlichen Verbindungsstege und den zusätzlichen Verankerungen 90 zum Substrat. Diese konstruktiven Zusatzmaßnahmen stabilisieren die Zusatzmasse 8 gegenüber störenden Drehmomenten.

Obwohl die vorliegende Erfindung vorstehend anhand bevorzugter Ausführungsbeispiele beschrieben wurde, ist sie darauf nicht beschränkt, sondern auf vielfältige Weise modifizierbar.

Insbesondere kann die Leiterschleife selbstverständlich auch eine andere als die rechteckige Geometrie aufweisen.

Auch muß das mikromechanische Grundmaterial nicht Silizium sein, sondern kann ein beliebiges Grundmaterial sein.

Desweiteren muß die Anregung der deformierbaren Abschnitte der Leiterschleife nicht kapazitiv erfolgen, sondern kann auch induktiv, magnetisch oder auf eine sonstige weise vollzogen werden.

Die Auswertung der Meßsignale muß nicht in der Zeitdomäne erfolgen, sondern kann auch durch entsprechende Fouriertransformationen geschehen.

Schließlich muß der Magnetfeldsensor nicht unbedingt ein mikromechanisches Bauteil sein, sondern kann in Abhängigkeit von den zu erfassenden Magnetfeldern auch ein makromechanisches Bauteil sein.

Magnetfeldsensor

| BEZUGSZEICHENLISTE: | |
|---|---|
| 1,1',1'',1''', 1'''' | Leiterschleife |
| 2 | Längsseiten |
| 3,3' | Breitseiten |
| 4,4',4'',9 | Stege |
| 5,6,6' | Anschlußpads |
| B | Magnetfeld |
| U | induzierte Spannung |
| v | Geschwindigkeit |
| 7, 90 | Verankerung |
| 20, 70, 80 | Kammstrukturen |
| 2',2'',2''' | Federstege |
| 8 | Zusatzmasse |
| R1-R4 | Ersatzwiderstände |
| C1,C2 | Ersatzkapazitäten |
| U1,U2 | Anregungsspannungen |
| MASSE | Erdpotential |

**Patentansprüche**

**1.** Magnetfeldsensor, insbesondere in der Technologie der Oberflächenmikromechanik herstellbarer Magnetfeldsensor, mit:

einer Leiterschleife (1; 1'; 1''; 1'''; 1''''), welche zumindest einen deformierbaren Abschnitt (2; 2'; 2''; 2''') aufweist;

einer Deformationseinrichtung (20; 7, 70; 8, 80) zum Deformieren des deformierbaren Abschnitts (2; 2'; 2''; 2''') der Leiterschleife (1; 1'; 1''; 1'''; 1'''') mit einer vorbestimmbaren Zeitabhängigkeit;

einer Spannungserfassungseinrichtung zum Erfassen der an den Enden der Leiterschleife (1; 1'; 1''; 1'''; 1'''') beim Deformieren in Gegenwart eines Magnetfelds (B) induzierten Spannung (U);

einer Magnetfeld-Ermittlungseinrichtung zum Ermitteln des gegenwärtigen statischen und/oder dynamischen Magnetfelds (B) unter Berücksichtigung von zumindest der Zeitabhängigkeit des Deformierens; und

dass die Deformationseinrichtung (20; 7, 70; 8, 80) derart gestaltet ist, dass sie die deformierbaren Abschnitte durch Erzeugen von elektrostatischen Anziehungskräften über eine kapazitive Kopplung zwischen Elektroden der Deformationsstruktur (20; 7, 70; 8, 80) deformiert.

**2.** Magnetfeldsensor nach Anspruch 1, **dadurch gekennzeichnet, dass** die Leiterschleife (1, 1', 1'', 1''', 1'''') im undeformierten Zustand eine Fläche mit zwei im wesentlichen zueinander parallelen Längsseiten (2) umschließt und die Deformationseinrichtung (20, 7, 70, 8, 80) die zwei Längsseiten (2) zur Änderung der umschlossenen Fläche deformiert.

**3.** Magnetfeldsensor nach Anspruch 2, **dadurch gekennzeichnet, dass** die Leiterschleife (1, 1', 1'', 1''', 1'''') derart gestaltet ist, dass sich bei gleichsinniger Bewegung der Längsseiten (2) Teile (4, 4', 3, 3') der Leiterschleife (1, 1', 1'', 1''', 1'''') mitbewegen, während sie bei gegensinniger Bewegung der Längsseiten (2) ortsfest bleiben.

**4.** Magnetfeldsensor nach einem der vorhergehenden Ansprüche, der in der Technologie der Oberflächenmikromechanik hergestellt ist, mit einem Substrat, das vorzugsweise aus Silizium ist, **dadurch gekennzeichnet, dass** daß die Leiterschleife (1; 1'; 1''; 1'''; 1'''') im wesentlichen eine Rechteckform aufweist, deren Längsseiten (2) schwebend über dem Substrat angeordnet sind und durch die Deformationseinrichtung (20; 7, 70; 8, 80) deformierbar sind und deren Breitseiten (3, 3') schwebend am Substrat aufgehängt sind.

**5.** Magnetfeldsensor nach Anspruch 4, **dadurch gekennzeichnet, daß** die Leiterschleife (1; 1'; 1"; 1'"; 1"") aufweist:

eine durchgehende nicht-deformierbare erste Breitseite (3) mit einer größeren Dicke als die Längsseiten (2), die über mindestens einen deformierbaren schwebenden Steg (4; 4") mit im wesentlichen der Dicke der Längsseiten (2) mit mindestens einem im Substrat verankerten Anschlußpad (5; 5') verbunden ist.

**6.** Magnetfeldsensor nach Anspruch 4 oder 5, **dadurch gekennzeichnet, daß** die Leiterschleife (1; 1'; 1"; 1'"; 1"") aufweist:

eine geteilte nicht-deformierbare zweite Breitseite (3') mit einer größeren Dicke als die Längsseiten (2), deren Teile über einen jeweiligen deformierbaren schwebenden Steg (4') it im wesentlichen der Dicke der Längsseiten (2) mit einem jeweiligen Substrat verankerten Anschlußpad (6; 6') verbunden ist.

**7.** Magnetfeldsensor nach Anspruch 4 oder 5, **dadurch gekennzeichnet, daß** die Längsseiten (2) an ihrem ersten Ende über einen deformierbaren schwebenden ersten Federsteg (2') mit im wesentlichen der Dicke der Längsseiten (2) mit einem im Substrat verankerten Anschlußpad (6; 6') verbunden sind.

**8.** Magnetfeldsensor nach Anspruch 5, **dadurch gekennzeichnet, daß** die Längsseiten (2) an ihrem zweiten Ende über einen deformierbaren schwebenden zweiten Federsteg (2 "; 2'") mit im wesentlichen der Dicke der Längsseiten (2) mit der durchgehenden nicht-deformierbaren ersten Breitseite (3) verbunden sind.

**9.** Magnetfeldsensor nach einem der Ansprüche 4 bis 8, **dadurch gekennzeichnet, daß** in der Mitte der deformierbaren Längsseiten (2) eine Zusatzmasse (8) über dem Substrat schwebend vorgesehen ist.

**10.** Magnetfeldsensor nach einem der Ansprüche 4 bis 9, **dadurch gekennzeichnet, daß** als Deformationseinrichtung (20; 7, 70; 8, 80) eine mit den Längsseiten (2) verbundene Kammantriebseinrichtung (7, 70) vorgesehen ist.

**Claims**

**1.** Magnetic field sensor, in particular a magnetic field sensor which can be manufactured using surface micromechanics technology, having:

a conductor loop (1; 1'; 1"; 1'"; 1"") which has at least one deformable section (2; 2'; 2"; 2'");

a deformation device (20; 7, 70; 8, 80) for deforming the deformable section (2; 2'; 2"; 2'") of the conductor loop (1; 1'; 1"; 1'"; 1"") with a predeterminable time dependence;

a voltage detection device for detecting the voltage (U) which is induced at the ends of the conductor loop (1; 1'; 1"; 1'"; 1"") when deformation is effected in the presence of a magnetic field (B);

a magnetic field determination device for determining the actual static and/or dynamic magnetic field (B), taking into account at least the time dependence of the deformation process;

**characterized in that** the deformation device (20; 7, 70; 8, 80) is configured in such a manner that it deforms the deformable sections by generating electrostatic attractive forces by way of capacitive coupling between the electrodes in the deformation structure (20; 7, 70; 8, 80).

**2.** Magnetic field sensor according to Claim 1, **characterized in that**, in the undeformed state, the conductor loop (1, 1', 1", 1'", 1"") encloses an area with two essentially parallel longitudinal sides (2), and the deformation device (20, 7, 70, 8, 80) deforms the two longitudinal sides (2) in order to alter the enclosed area.

**3.** Magnetic field sensor according to Claim 2, **characterized in that** the conductor loop (1, 1', 1", 1'", 1"") is configured in such a manner that, when the longitudinal sides (2) move in the same sense, parts (4, 4', 3, 3') of the conductor loop (1, 1', 1", 1'", 1"") concomitantly move, whereas, when the longitudinal sides (2) move in opposite senses, the said parts remain fixed in position.

**4.** Magnetic field sensor according to one of the preceding claims, which is manufactured using surface micromechanics technology and has a substrate which is preferably made of silicon, **characterized in that** the conductor loop (1; 1'; 1"; 1'"; 1"") essentially has a rectangular shape, the longitudinal sides (2) of which are suspended above the substrate and can be deformed by the deformation device (20; 7, 70; 8, 80), and the width sides (3, 3') of which are suspended from the substrate.

**5.** Magnetic field sensor according to Claim 4, **characterized in that** the conductor loop (1; 1'; 1"; 1'";

1"") has:

a continuous non-deformable first width side (3) which is thicker than the longitudinal sides (2) and is connected to at least one terminal pad (5; 5') (anchored in the substrate) via at least one deformable suspended web (4; 4") which is essentially of the same thickness as the longitudinal sides (2).

6. Magnetic field sensor according to Claim 4 or 5, **characterized in that** the conductor loop (1; 1'; 1"; 1"'; 1"") has:

a split non-deformable second width side (3') which is thicker than the longitudinal sides (2) and the parts of which are connected to a respective terminal pad (6; 6') (anchored in the substrate) via a respective deformable suspended web (4') which is essentially of the same thickness as the longitudinal sides (2).

7. Magnetic field sensor according to Claim 4 or 5, **characterized in that**, at their first end, the longitudinal sides (2) are connected to a terminal pad (6; 6') (anchored in the substrate) via a deformable suspended first spring web (2') which is essentially of the same thickness as the longitudinal sides (2).

8. Magnetic field sensor according to Claim 5, **characterized in that**, at their second end, the longitudinal sides (2) are connected to the continuous non-deformable first width side (3) via a deformable suspended second spring web (2"; 2"') which is essentially of the same thickness as the longitudinal sides (2).

9. Magnetic field sensor according to one of Claims 4 to 8, **characterized in that** an additional mass (8) is suspended above the substrate in the centre of the deformable longitudinal sides (2).

10. Magnetic field sensor according to one of Claims 4 to 9, **characterized in that** a comb drive device (7, 70), which is connected to the longitudinal sides (2), is provided as the deformation device (20; 7, 70; 8, 80).

**Revendications**

1. Détecteur de champ magnétique notamment détecteur réalisable en technique de micromécanique des surfaces comprenant :

- une boucle conductrice (1, 1', 1", 1"', 1"") ayant au moins un segment déformable (2, 2', 2", 2"'),
- une installation de déformation (20, 7, 70, 8, 80) pour déformer le segment déformable (2, 2', 2", 2"') de la boucle conductrice (1, 1', 1", 1"', 1"") avec une relation de temps prédéterminée,

- une installation de détection de tension pour saisir aux extrémités de la boucle conductrice (1, 1', 1", 1"', 1"") la tension induite (U) par la déformation sous l'action d'un champ magnétique (B),
- une installation de détermination de champ magnétique pour déterminer le champ magnétique (B) présent, statique et/ou dynamique en tenant compte au moins de la dépendance du temps de la déformation, dans lequel
- l'installation de déformation (20, 7, 70, 80, 80) est conçue pour déformer les segments déformables en générant des forces d'attraction électrostatiques par un couplage capacitif entre les électrodes de la structure de déformation (20, 7, 70, 8, 80).

2. Détecteur de champ magnétique selon la revendication 1, **caractérisé en ce que** la boucle conductrice (1, 1', 1", 1"', 1"") à l'état non déformé est une surface à deux grands côtés (2) essentiellement parallèles, et l'installation de déformation (20, 7, 70, 8, 80) déforme les deux grands côtés (2) pour modifier la surface enveloppée.

3. Détecteur de champ magnétique selon la revendication 2, **caractérisé en ce que** la boucle conductrice (1, 1', 1", 1"', 1"") est conçue de façon que pour un mouvement de même sens des grands côtés (2), les parties (4, 4', 3, 3') de la boucle conductrice (1, 1', 1", 1"', 1"") se déplacent également alors que pour un mouvement de sens opposé, les grands côtés restent fixes.

4. Détecteur de champ magnétique selon l'une quelconque des revendications précédentes, réalisé en technique de micromécanique des surfaces comprenant un substrat de préférence en silicium, **caractérisé en ce que** la boucle conductrice (1, 1', 1", 1"', 1"") présente essentiellement une forme rectangulaire dont les grands côtés (2) flottent au-dessus du substrat et peuvent être déformés par l'installation de déformation (20, 7, 70, 8, 80) et dont les côtés larges (3, 3') sont accrochés de manière flottante au substrat.

5. Détecteur de champ magnétique selon la revendication 4, **caractérisé en ce que** la boucle conductrice (1, 1', 1", 1"', 1"") comprend :

- un premier côté large (3) continu non déformable dont l'épaisseur est plus grande que celle des grands côtés (2) en étant relié par au moins une branche déformable (4, 4") flottante à une patte de branchement (5, 5') accrochée au substrat et qui correspond pour l'essentiel à l'épaisseur des grands côtés (2).

6. Détecteur de champ magnétique selon l'une quelconque des revendications 4 ou 5, **caractérisé en ce que** la boucle conductrice (1, 1', 1", 1"', 1"") comprend :

- un second côté large (3') divisé, non déformable, ayant une épaisseur plus grande que celle des grands côtés (2) et dont les parties sont reliées par une entretoise flottante (4') respectivement déformable, pour l'essentiel adaptée à l'épaisseur des grands côtés (2) avec une patte de branchement (6, 6') accrochée dans le substrat respectif.

7. Détecteur de champ magnétique selon l'une quelconque des revendications 4 ou 5, **caractérisé en ce que** les grands côtés (2) sont reliés au niveau de leur première extrémité par une première branche élastique (2') déformable flottante, à une patte de raccordement (6, 6') accrochée au substrat et qui correspond pour l'essentiel à l'épaisseur des grands côtés (2).

8. Détecteur de champ magnétique selon la revendication 5, **caractérisé en ce que** les grands côtés (2) sont reliés au niveau de leur seconde extrémité avec le premier côté large (3) non déformable, continu, par une seconde branche élastique (2", 2"'), déformable, flottante, ayant principalement l'épaisseur des grands côtés (2).

9. Détecteur de champ magnétique selon l'une quelconque des revendications 4 à 8, **caractérisé par** une masse supplémentaire (8) au milieu des grands côtés déformables (2) et qui est flottante sur le substrat.

10. Détecteur de champ magnétique selon l'une quelconque des revendications 4 à 9, **caractérisé en ce que** l'installation de déformation (20, 7, 70, 8, 80) comporte une installation d'entraînement de peigne (7, 70) reliée aux grands côtés (2).

Fig. 1

Fig. 2

Fig. 3

Fig. 4

Fig. 5

Fig. 6

Fig. 7